# EUROPEAN PATENT APPLICATION

(11) **EP 2 549 559 A1**
(43) Date of publication of application: **23.01.2013**
(21) Application number: 10847664.9
(22) Date of filing: 15.03.2010
(51) Int. Cl.: H01L 51/44, H01L 51/48, H01L 31/055

(54) **ORGANIC SOLAR CELL AND METHOD FOR MANUFACTURING THE SAME**

(71) Applicant: Ocean's King Lighting Science&Technology Co., Ltd., Guangdong 518054 (CN)
(72) Inventor: ZHOU, Mingjie, Shenzhen Guangdong 518054 (CN); HUANG, Jie, Shenzhen Guangdong 518054 (CN); SUN, Xiaoyu, Shenzhen Guangdong 518054 (CN)
(74) Representative: Hart-Davis, Jason
(86) International application number: PCT/CN2010/071056
(87) International publication number: WO 2011/113195

(57) **Abstract**

An organic solar cell (20) and a method for manufacturing the same are provided. The organic solar cell (20) includes a light reflective electrode (11), a photosensitive layer (23) arranged over the light reflective electrode (11), a transparent electrode (16) arranged over the photosensitive layer (23), an up-conversion structure (18) arranged over the transparent electrode (16), and a transparent insulation layer (17) arranged between the transparent electrode (16) and the up-conversion structure (18), wherein the up-conversion structure (18) includes up-conversion materials which have the up-conversion capability for spectrum, and the photosensitive layer (23) includes a mixed heterojunction structure which is formed by mixing at least electron donor materials and electron acceptor materials. High photoelectric conversion performance and enhanced electric properties of the organic solar cell can be obtained.

## Description

### Field of the invention

The present invention belongs to the technical field of photoelectric conversion, and specifically relates to an organic solar cell and a method for manufacturing the same.

### Background of the invention

Due to the deterioration of the world-wide environment of the energy sources, and the effects of carbon dioxide, etc. produced from fossil resources on the atmosphere, the development of renewable green energy sources has become the most important task for solving the current problem about energy sources. Among them, the solar cell is considered to be the most prospective and most valuable green energy source since it is free of pollution and easy to be obtained. Solar cells have been studied for more than half a century since 1950s. Depending on the materials, silicon solar cells, Group III-V semi-conductive solar cells, copper-indium-selenium (or copper-indium-gallium-selenium) solar cells, cadmium telluride solar cells, nano-titanium dioxide (dye-sensitized) solar cells and organic solar cells are developed. Organic solar cells are new low-cost solar cells which were developed in the last twenty years, which may actually change the life style of the human being.

Organic solar cells are manufactured from low-cost and simple organic raw materials, which significantly reduces the cost thereof. The highly effective electron donor-electron acceptor exciton dissociation interface and the vast choices of the organic materials render the organic solar cell with broad development prospect and great of application. In addition to the advantages in the coasts, organic solar cells are characterized in that they are foldable, and have good flexibility, and therefore have very broad application prospect. Among them, polymeric solar cells may be manufactured by simple processes such as sol-gel, screen printing, and the like, and therefore very suitable for large-scale production. Accordingly, they have drawn more and more attention from research unities and enterprises.

However, the current polymeric solar cells are generally low in their efficiencies, and are therefore far from commercialization. The main factors hindering the energy conversion efficiency include the incompatibility between the spectral response range of the cells and the ground radiation spectrum of the sunlight, relatively low carrier mobility of the polymeric material per se, as well as the low transport efficiency of the carriers.

For organic solar cells, there are many factors responsible for their low energy conversion efficiency. An important reason is that the utilization rate of the sunlight radiation by the organic materials is low, and that the absorption spectrum of the material is incompatible with the emission spectrum of the sunlight. The absorption of sunlight by conventional organic materials is mainly in the range of visible lights (wavelength range: 380 nm - 780 nm), whereas the emission spectrum of sunlight includes lights with all wavelengths, such as UV lights, IR lights, etc., wherein the energy of the IR lights represents about 47% of the energy of the full-wavelength sunlight. Obviously, it is a great energy loss as conventional organic small molecular solar cells cannot sufficiently utilize the IR part of the sunlight spectrum. Accordingly, organic materials absorb only a small fraction of the solar energy, resulting in a low utilization rate of the solar energy.

Another factor responsible for the low energy conversion efficiency is that conventional heterojunction structure restricts the efficiency of the diffusion of the excitons to the dissociation interface, thereby restricting its photoelectric energy conversion capability. In conventional organic small molecular solar cells with heterojunction structure, the photosensitive layer of the cell absorbs light to produce excitons (electron-hole pair), which is electrically neutral. Only when the excitons diffuse to the heterojunction and is dissociated into free carriers, i.e. free electrons and holes, it is possible that the excitons contribute to the photoelectric output of the cell. However, the diffusion distance of the excitons in organic materials is relatively short, generally 10-20 nm. Accordingly, only the excitons within 10-20 nm from the heterojunction can diffuse to the interface and be dissociated into free carriers, whereas the excitons produced farther from the heterojunction would lose their energy in vain, and make no contribution to the photoelectric conversion. This results in that current organic solar cells have relatively low energy conversion efficiency.

### Summary of the Invention

Accordingly, the present invention provides an organic solar cell with a high utilization rate of the solar energy, a high utilization rate of the excitons, and improved electric properties, as well as a simple and low-cost method for preparing an organic solar cell.

An organic solar cell, comprising a light reflective electrode, a photosensitive layer arranged on the light reflective electrode, a transparent electrode arranged on the photosensitive layer, an up-conversion structure arranged on the transparent electrode, and a transparent insulation layer arranged between the transparent electrode and the up-conversion structure, wherein the up-conversion structure comprises an up-conversion material having up-conversion capability for spectrum, and the photosensitive layer comprises at least a mixed heterojunction structure formed by mixing an electron donor material and an electron acceptor material.

In addition, a method for manufacturing an organic solar cell, comprising the following steps:
providing a transparent insulation layer having a first surface and a second surface opposite to each other;
forming a transparent electrode on the first surface of the transparent insulation layer;
forming a photosensitive layer on the transparent electrode, wherein the photosensitive layer comprises at least a mixed heterojunction structure formed by mixing an electron donor material and an electron acceptor material;
forming a light reflective electrode on the photosensitive layer;
forming an up-conversion structure on the second surface of the transparent insulation layer, thereby the transparent insulation layer is between the transparent electrode and the up-conversion structure, wherein the up-conversion structure comprises an up-conversion material having up-conversion capability for spectrum.

In the organic solar cell, on one hand, by arranging an up-conversion structure and utilizing the spectral conversion function of the up-conversion material, the lights which cannot be sufficiently absorbed and utilized by the cell, such as low-energy near IR photons, are converted to photons of visible wavelengths which have relatively higher energy, thereby increasing the utilization rate of sunlight energy by the organic solar cell, and improving its photoelectric conversion performance. On the other hand, the transparent insulation layer between the up-conversion structure and the transparent electrode ensures electrical separation of the up-conversion layer and the solar cell, avoiding the adverse effects of the up-conversion material on the photoelectric conversion of the solar cell, and enhancing the electric properties of the organic solar cell. Furthermore, by utilizing the mixed heterojunction structure, the exciton dissociation region is expanded, and the exciton utilization rate is increased, thereby increasing the internal quantum efficiency of the cell. In the method for manufacturing the organic solar cell, various layers are formed in predetermined steps, the procedure is simple with low costs, thereby having broad application prospect.

### Brief Description of the Drawings

The present invention will be described in detail referring to the Figures and Examples, in which:
Figure 1 is a structural scheme of an organic solar cell of a first embodiment of the present invention;
Figure 2 is a structural scheme of an organic solar cell of a second embodiment of the present invention;
Figure 3 is a flow chart of the method for manufacturing an organic solar cell of an embodiment of the present invention.

### Detailed Description of the preferred Embodiments

In order to make the object, the technical solutions and the advantageous effects of the present invention more obvious, the present invention will be described in detail in combination with the Figures and Examples. It shall be appreciated that the specific embodiments described herein are only for illustration of the present invention and shall not be construed to limit the present invention.

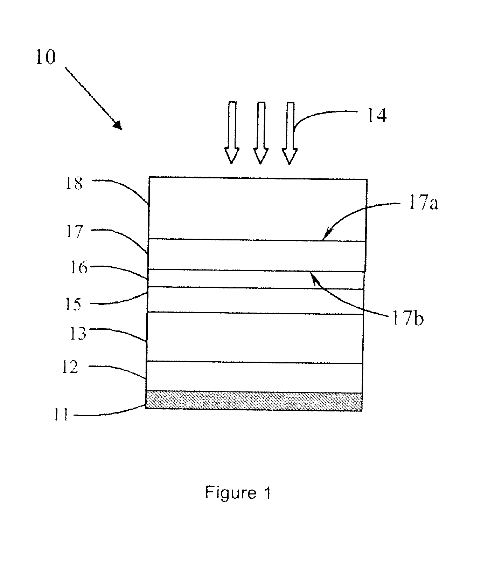

Refer to Figure 1, which shows the structure of an organic solar cell of a first embodiment of the present invention. The organic solar cell 10 of the present embodiment comprises a light reflective electrode 11, a photosensitive layer 13 arranged on the light reflective electrode 11, a transparent electrode 16 arranged on the photosensitive layer 13, and an up-conversion structure 18 arranged on the transparent electrode 16. A transparent insulation layer 17 is arranged between the transparent electrode 16 and the up-conversion structure 18. The photosensitive layer 13 comprises a mixed heterojunction structure formed by mixing an electron donor material and an electron acceptor material. The up-conversion structure 18 comprises an up-conversion material having up-conversion capability for spectrum. In particular, the above parts are of stacked layer structures.

In the embodiment shown in the figure, a buffer layer is arranged at each side of the photosensitive layer 13. In other words, a first buffer layer 12 is arranged between the light reflective electrode 11 and the photosensitive layer 13, and a second buffer layer 15 is arranged between the photosensitive layer 13 and the transparent electrode 16.

The light reflective electrode 11 may be formed from high reflective material, which may be, but not limited to, a metal film electrode of Au, Ag, Al, Ca-Al or Mg-Ag, or a high reflective electrode comprising a metal oxide such as ITO or ZnO, and may be used as the cathode or the anode of the cell. In the present embodiment, the light reflective electrode 11 has a layer structure, and is an electrode layer having a thickness in the micrometer or nanometer range, for example, but not limited to, 50 nm - 2 µm, preferably 100-200 nm. In a specific embodiment, the light reflective electrode 11 may be formed with a stripe-like electrode pattern, for example in a form of long and straight stripes.

In the embodiment, the photosensitive layer 13 comprises a mixed heterojunction structure which is formed by mixing an electron donor material and an electron acceptor material in a predetermined ratio. For example, the mass ratio of the electron donor material and the electron acceptor material may be 1 : 0.1 ∼ 1 : 10. preferably 1 : 0.5 ∼ 1 : 2. Accordingly, the mixed heterojunction structure is a mixture of the electron donor material the electron acceptor material which are mixed and blended with each other. The electron donor material and the electron acceptor material are mixed together homogeneously. The mixed heterojunction structure of the present embodiment is a network matrix structure with a large charge-producing interface formed from the electron donor and the electron acceptor, and is the main region in the cell to produce photo-induced excitons and dissociate them into free electron and hole carriers, and to output photocurrent. It may be formed for example by spin coating, thereby forming a homogeneous phase of the donor material and acceptor material, and ensuring the smooth output of the photocurrent. Of course, it may also be formed by vacuum deposition or sputtering, but is not limited thereto.

The above electron donor material may be polyphenylenevinylene (PPV) or a derivative thereof, polythiophene material, polyfluorene material, polycarbazole material, polydithienocyclopentane material, or the like, wherein polyphenylenevinylene (PPV) or a derivative thereof may be for example poly[2-methoxy-5-(2'-vinyl-hexyloxy)polyphenylenevinylene] (MEH-PPV), poly(2-methoxy-5-(3',7'-dimethyloctyloxy)-1,4-phenylenevinylene (MDMO-PPV); the polythiophene material may be for example poly(3-hexylthiophene) (P3HT); the polyfluorene material may be for example a copolymer containing benzothiadiazole unit and fluorene unit; the polycarbazole material may be for example a copolymer containing benzothiadiazole unit and carbazole unit, the polydithienocyclopentane material may be for example a copolymer containing benzothiadiazole unit and bithiophene unit; and other polymeric materials may be, but not limited to, polymers containing units such as quinoxaline, thienopyrrole, and thienopyrazine. The electron acceptor material may be, but not limited to, polyperylene imide material, C₆₀ or a derivative thereof (e.g. PCBM), or C₇₀ or a derivative thereof (e.g. PC₇₀BM).

The photosensitive layer 13 is the photosensitive region for the whole cell to absorb photons and produce photocurrent and photovoltage. The photosensitive layer 13 may have a thickness in the nanometer range, for example, but not limited to, 10-200 nm, preferably 20-160 nm.

The materials for the first and second buffer layers 12 and 15 may be the same or different from each other, and may be one or more of the following: polyethylenedioxythiophene : polystyrenesulfonate composite (PEDOT:PSS), titanium oxides (TiOₓ), BCP, Alq₃ or LiF, wherein Alq₃ stands for 8-Tris-Hydroxyquinoline Aluminum, BCP stands for 2,9-dimethyl-4,7-diphenyl-1,10-phenanthroline.

The thicknesses of the first and second buffer layers 12 and 15 may be the same or different from each other, and may be in the nanometer range, specifically 5-20 nm, preferably 5-10 nm.

The above materials for the first and second buffer layers 12 and 15 may play a role mainly of modifying the interface between the electrode and the photosensitive layer. On one hand, the interface becomes smoother; on the other hand, this facilitates the charge transfer in the interface. In addition, they can increase the work function of the anode, and partly block the excitons.

The transparent electrode 16 may be made from a transparent material with good conductivity, for example, but not limited to, oxide transparent electrodes such as indium tin oxide (ITO), aluminum zinc oxide (AZO), gallium zinc oxide (GZO), indium zinc oxide (IZO); or metal film electrodes such as Au film, Al film, Ag film; or carbon nanotube conductive films. The transparent electrode 16 may be used as the anode or the cathode of the cell or as the counter electrode for the light reflective electrode. In the present embodiment, the transparent electrode 16 has a layer structure, and is a transparent layer having a thickness in the micrometer or nanometer range, for example, but not limited to, 50 nm -2 µm, preferably 100-200 nm. In a specific embodiment, corresponding to the structure of the light reflective electrode 11, the transparent electrode 16 may be formed with a stripe-like electrode pattern, for example in a form of long and straight stripes.

The transparent insulation layer 17 may be made mainly from a transparent insulation material. For example, it may be a glass layer or a transparent plastic layer, wherein the glass material may be, but not limited to, quartz glass, silicate glass, high-silica glass, or soda time glass; and the transparent plastic layer may be, but not limited to, polyvinylchloride (PVC), polycarbonate (PC) or polyester (PET). Said transparent insulation layer 17 is arranged between the transparent electrode 16 and the up-conversion structure 18 to insulatingly separate these two layer structures, ensuring that the up-conversion structure 18 is electrically independent from the photosensitive layer 13 and the transparent electrode 16, avoiding the adverse effects of the up-conversion material on the internal photoelectric conversion of the organic solar cell 10, thereby making it possible to optimize the performances of the up-conversion structure, the cell units of the organic solar cell 10 (i.e. comprising at least the photosensitive layer 13, the transparent electrode 16 and the light reflective electrode 11) separately, to achieve an optimized performance of the whole cell system. The thickness of the transparent insulation layer 17 may be, but not limited to, 0.5-5 mm, preferably 1-3 mm. The relatively thicker transparent insulation layer 17 may be used as a substrate for supporting the other layers.

The transparent insulation layer 17 has a first surface 17a and a second surface 17b, wherein the first surface 17a is the surface adjacent to the second buffer layer 15, and the second surface 17b is the surface on which the up-conversion structure 18 is arranged.

The up-conversion material in the up-conversion structure 18 may include halide, oxide, sulfide or a combination thereof which is mono- or double-doped with rare earth ions, wherein the halide is preferably fluoride; the oxide may be rare earth oxide, zinc oxide, zirconium oxide or complex oxide; and the sulfide may be rare earth sulfide. Specifically, the up-conversion material may be, but not limited to, BaY₂F₈, KZnF₃, NaYF₄, NaYb(WO₄)₂, Ga₂S₃-La₂O3, Y₂O₃, Gd₂O₃, ZrO₂, ZnO, BaTiO₃, ZrF₂-SiO₂ or ZnO-SiO₂ which is mono- or double-doped with rare earth ions. The mono- or double-doped rare earth ions include Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ or Tb³⁺/Er³⁺. The total doping molar ratio of the rare earth ions is not particularly limited, and may be determined as required. For example, the total doping molar ratio of the rare earth ions based on the substrate (i.e. halide, oxide, sulfide or a combination thereof) may be 1% - 60%, but is not limited thereto.

In double-doped rare earth ions, such as in Yb³⁺/Ho³⁺, Yb³⁺/Tm³⁺, Yb³⁺/Pr³⁺, Yb³⁺/Er³⁺ or Tb³⁺/Er³⁺, the molar ratio of the two ions is 1 : 0.1 ∼ 1 : 1, preferably 1 : 0.1 ∼ 1 : 0.5.

The up-conversion structure 18 may be in a form of a film comprising an up-conversion material, or of a composite structure comprising an up-conversion material coated with an oxide film. The oxide film used for coating may be ZnO:Al, or SnO₂:Sb. In the composite structure comprising an up-conversion material coated with an oxide film, the composite structure of coated up-conversion material can ensure the stability of the up-conversion material, thereby making the up-conversion function of the up-conversion structure 18 stable and long-lasting. The thickness of the up-conversion structure 18 may be, but not limited to, 500-600 nm. The up-conversion material has a function of "spectral regulation", in which the low-energy lights which cannot be sufficiently absorbed and utilized by the cell, such as photons in near IR, far IR and other range, are converted to photons of visible wavelengths which have relatively higher energy, thereby increasing the absorption and utilization rate of sunlight energy, and improving the photoelectric conversion performance of the cell.

Accordingly, as shown in Figure 1, under the radiation of sunlight 14, the sunlight enters from the side of the up-conversion structure 18. By the up-conversion process, photons in for example the IR range are converted to photons of visible wavelengths, which pass through the transparent insulation layer 17 and the transparent electrode 16, are absorbed by the mixed heterojunction structure in the polymeric solar cell photosensitive layer 13, and are converted to free carriers, which are guided out through the carrier transportation layer to form a photocurrent. The photosensitive layer 13 comprises a mixed heterojunction structure in which the electron donor material and the electron acceptor material are mixed homogeneously to form a network matrix structure from the electron donor and the electron acceptor, which expand the region in which the photo-induced excitons are dissociated into free carriers and a photocurrent is formed, increase the exciton dissociation efficiency, and facilitate the exciton diffusion and migration. These ensure smooth output of the photocurrent, avoid the exciton diffusion defects in the current heterojunctions, and thereby significantly increase the photoelectric conversion efficiency of the sunlight by the cell.

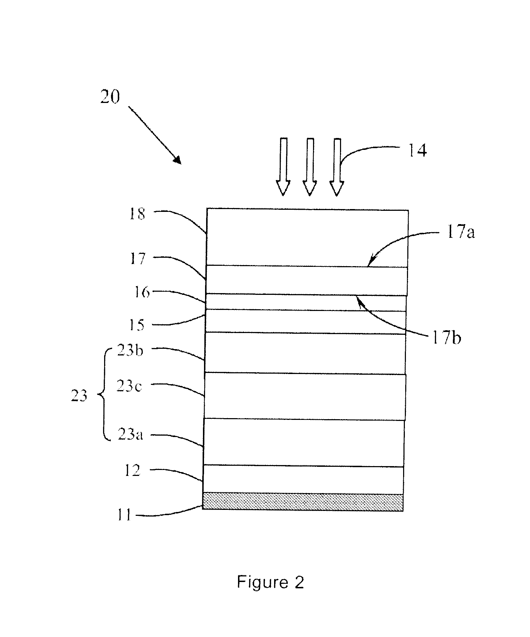

Refer to Figure 2, which shows the structure of an organic solar cell of a second embodiment of the present invention. The organic solar cell 20 of the present embodiment is substantially the as the organic solar cell of the first embodiment, except for the structure of the photosensitive layer. The same reference numbers in Figures 2 and 1 refer to the same elements, and will not be described repeatedly.

The photosensitive layer 23 of the present embodiment has a three-layer structure, including sequentially stacked a first photosensitive layer 23a and a second photosensitive layer 23b as well as a third photosensitive layer 23c arranged between the first and the second photosensitive layers 23a and 23b, wherein the first photosensitive layer 23a comprises an electron donor material; the second photosensitive layer 23b comprises an electron acceptor material; and the third photosensitive layer 23c has the same structure as that of the above photosensitive layer 13. In addition to the materials for the above photosensitive layer 13, the electron donor material may be for example, but not limited to, at least one of phthalocyanine dyes, pentacene, porphyrins and cyanine dyes. In addition to the materials for the above photosensitive layer 13, the electron acceptor material may be for example, but not limited to, at least one of tetracarboxy perylene derivatives (e.g. perylene-3,4,9,10-tetracarboxylic dianhydride, PTCDA), C₆₀, C₇₀, perylene and derivatives thereof. Preferably, the electron donor and acceptor materials in the first and the second photosensitive layers 23a and 23b are the same as the electron donor and acceptor materials in the third photosensitive layer 23c, respectively.

In the embodiment shown in the figure, the second photosensitive layer 23b is arranged adjacent to the transparent electrode 16, i.e. near the light incidence side, and the first photosensitive layer 23a is adjacent to the light reflective electrode 11. It shall be understood that the first and the second photosensitive layers 23a and 23b may be arranged in a reversed sequence, i.e. the first photosensitive layer 23a is arranged adjacent to the transparent electrode 16, i.e. near the light incidence side, and the second photosensitive layer 23b is adjacent to the light reflective electrode 11.

In this three-layer structure of the photosensitive layer, the first and the second photosensitive layers 23a and 23b act as the layer for absorbing lights and transporting the carriers. Of course, the third photosensitive layer 23c may also play the same role and have the same structure as that of the photosensitive layer 13 in the first embodiment. This three-layer structure may expand the region in which the photo-induced excitons are dissociated into free carriers and a photocurrent is formed, increase the exciton dissociation efficiency, and facilitate the increase of the photoelectric conversion efficiency.

It shall be understood that the materials used for the photosensitive layer in the above two embodiments may be used interchangeably. For example, the electron donor and acceptor materials in the three photosensitive layers 23a, 23b, 23c of the second embodiment may also be the corresponding polymer materials used in the photosensitive layer 13 as donor and acceptor, and vice versa.

It shall be also understood that structures comprising only two layers (including one of the first and the second photosensitive layers 23a and 23b with the third photosensitive layer 23c) or more layers (e.g. multiple layers including the photosensitive layer 13 or 23c) may be employed in other embodiments. These are all within the scope of the present invention, and the present invention shall not be limited by the number of layers and arrangement modes thereof in the above embodiments.

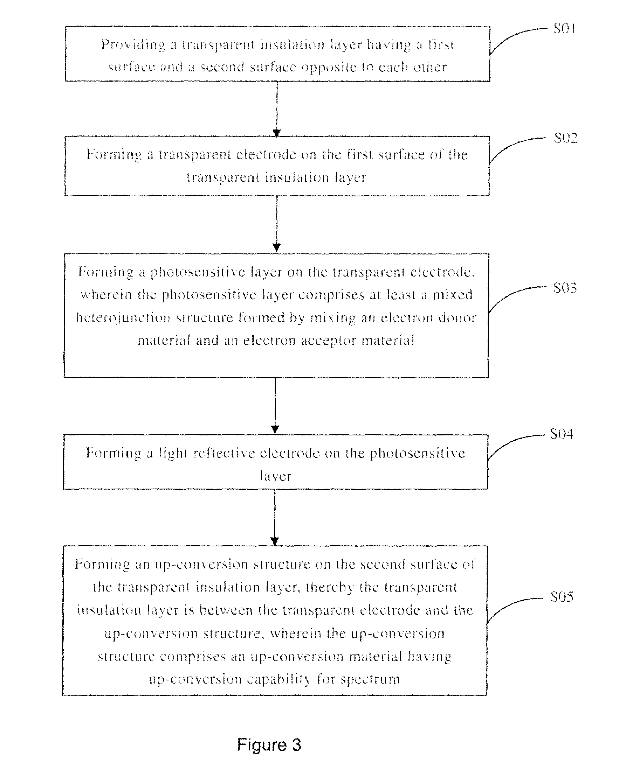

Refer to Figure 3, which shows the method for manufacturing an organic solar cell of an embodiment of the present invention, comprising the following steps:
S01: providing a transparent insulation layer having a first surface and a second surface opposite to each other;
S02: forming a transparent electrode on the first surface of the transparent insulation layer;
S03: forming a photosensitive layer on the transparent electrode, wherein the photosensitive layer comprises at least a mixed heterojunction structure formed by mixing an electron donor material and an electron acceptor material;
S04: forming a light reflective electrode on the photosensitive layer;
S05: forming an up-conversion structure on the second surface of the transparent insulation layer, thereby the transparent insulation layer is between the transparent electrode and the up-conversion structure, wherein the up-conversion structure comprises an up-conversion material having up-conversion capability for spectrum.

In the above steps, the materials for each layer correspond to the materials, composition and structures described above, and will not be described repeatedly. In the following, two methods for manufacturing the organic solar cell of the first embodiment and the second embodiment will be described.

In the structure of the first embodiment, referring to Figure 1, the transparent insulation layer 17 has a first surface 17a and a second surface 17b. As described above, it may be made from a transparent insulation material such as glass or plastic, and the transparent insulation layer 17 may be used as a substrate for growing the subsequent films.

In step S02, the transparent electrode 12 may be deposited on the first surface 17a of the transparent insulation layer 17 by vacuum evaporation or sputtering to form a transparent film structure. In a specific embodiment, the transparent electrode 16 may be further photo-etched to form a desired stripe-like electrode pattern, which is used as the anode of the organic solar cell 10. The specific pattern may be determined as required.

Corresponding to the above structure, a second buffer layer 15 may be further formed on the transparent electrode 16, for example producing a polymeric conductive film such as PEDOT:PSS by spin coating, or growing a material such as TiOₓ, BCP, Alq₃ or LiF by evaporation, and used as the buffer layer 15 in Figure 1.

The photosensitive layer 13 is made by forming a mixed layer of an electron donor material and an electron acceptor material mixed in a predetermined ratio on the second buffer layer 15 by spin coating and wet deposition to form a mixed heterojunction structure as the photosensitive layer 13 in Figure 1. Before conducting the wet deposition, the electron donor material and the electron acceptor material may be dissolved in an organic solvent in advance, and sufficiently stirred with a magnetic stirrer to ensure sufficiently dissolution, to prepare a solution containing the electron donor material and the electron acceptor material in a mass ratio (e.g. mass ratio of the donor/acceptor materials) of 1 : 0.1 ~ 1 : 10, for use in the spin coating. The organic solvent may be, but not limited to, chloroform. The electron donor material solution and the electron acceptor material solution are spin coated in a predetermined ratio to prepare the desired photosensitive layer 13, wherein the spin speed is about 1500 rpm. The spin coated product may be further dried at 60-100°C for several tens of minutes.

Corresponding to the above structure again, a first buffer layer 12 may be further formed on the photosensitive layer 13, for example by producing a polymeric conductive film such as PEDOT:PSS by spin coating, or growing a material such as TiOₓ, BCP, Alq₃ or LiF by evaporation, which is used as the buffer layer 12 in Figure 1. When a polymeric conductive film such as PEDOT:PSS is produced by spin coating, the coated product is placed in an oven and heated at 60-100°C for 20-60 minutes. In a specific embodiment, the temperature in the oven is 90°C, and the heating time is 25 minutes.

The light reflective electrode 11 may be formed into an electrode layer having a thickness in the nanometer range by vacuum evaporation or sputtering in combination with stripe-like mask sheets. The process for forming the up-conversion structure 18 is as follows: source compounds for the elements in the up-conversion material (e.g. oxide, nitrite, oxalate or carbonate of the corresponding elements), as raw materials, are spin-coated on the second surface 17b of the transparent insulation layer 17, i.e. the surface on which the transparent electrode 16 is not deposited, by sol-gel method, thereby the transparent insulation layer 17 is between the transparent electrode 16 and the up-conversion structure 18.

Furthermore, after forming the above layers, the whole structure is further annealed at about 100-200°C for 5-30 minutes, for example at 160°C for 5 minutes. In another embodiment, the up-conversion structure 18 may be an up-conversion material coated with an oxide film, and formed on the second surface 17b of the transparent insulation layer 17, for example by chemical homogeneous co-precipitation method. The above halide, oxide, sulfide or a combination thereof which is mono- or double-doped with rare earth ions is coated with ZnO:Al etc. to form a transparent up-conversion structure.

The method for manufacturing the organic solar cell 20 in the second embodiment is substantially the same as that described above, except for the step for preparing the photosensitive layer. As the photosensitive layer 23 in the organic solar cell 20 has a three-layer structure, the preparation thereof comprises three steps: sequentially forming the second photosensitive layer 23b, the third photosensitive layer 23c and the first photosensitive layer 23a. Corresponding to the structure in Figure 2, a second buffer layer 15 may be formed on the transparent electrode 16 before forming the first and the second photosensitive layers 23a and 23b. The photosensitive layers 23a and 23b may both be formed by vacuum evaporation, which specifically comprises the following steps: in the growing chamber of a vacuum evaporation system with a pressure of about 10⁻⁶ Pa, the second photosensitive layer 23b (e.g. a C₆₀ electron acceptor layer) is grown by vacuum evaporation with the growing rate being controlled as 0.4 nm/s, until the desired thickness is achieved; the third photosensitive layer 23c (e.g. a mixed layer of CuPc phthalocyanine copper and C₆₀) is then grown on the freshly deposited second photosensitive layer 23b by vacuum evaporation with the growing rate being controlled as 0.15 nm/s, until the desired thickness is achieved; the first photosensitive layer 23a (e.g. a CuPc phthalocyaninecopper electron donor layer) is then grown on the third photosensitive layer 23c by vacuum evaporation with the growing rate being controlled as 0.3 nm/s, until the desired thickness is achieved. Corresponding to the structure of the photosensitive layer 23 described above, when the sequence of the first and the second photosensitive layers 23a and 23b is changed, the sequence for forming them is correspondingly changed.

It shall be understood that, when any one of the photosensitive layers is made from the polymeric material of the first embodiment, the former spin coating method may be employed, and the photosensitive layer of the corresponding polymeric material may be formed by wet deposition spin coating. Similarly, when the photosensitive layer 13 of the first embodiment employs the same material as that of the third photosensitive layer 23c, the photosensitive layer 13 may alternatively be formed by vacuum evaporation. In other words, the above two methods may be use interchangeably in respect of various types of photosensitive layers, and are not limited to those in the above embodiments.

A first buffer layer 12 may be further formed on the first photosensitive layer 23a. The first buffer layer 12 (e.g. TiOₓ, BCP, Alq₃, etc.) may be prepared by forming a 8-Tris-Hydroxyquinoline Aluminum Alq₃ film by vacuum evaporation with the growth rate being controlled as 0.1 nm/s, until the desired thickness is achieved. The two buffer layers 12 and 15 may be made from the same or different materials. As required, when a polymeric conductive film such as PEDOT:PSS is used, spin coating method may be employed to coat it on the transparent electrode 12 or the photosensitive layer 13; and when a material such as TiOₓ, BCP, Alq₃, etc. is used, it can be formed on the transparent electrode 12 or the photosensitive layer 13 by vacuum evaporation.

In a preferred embodiment of the present invention, each photosensitive layer and both buffer layers employ the same type of materials, respectively. For example, each photosensitive layer and both buffer layers may all employ polymeric materials, or small molecules formed by vacuum evaporation method. In a specific embodiment, the electron donor and acceptor materials in the photosensitive layer 13 and the photosensitive layer 23 may employ the polymeric materials described in the first embodiment; and both buffer layers may employ a polymeric conductive film such as PEDOT:PSS. In this way, all the layers may be prepared by spin coating. In this case, multiple successive steps may all employ spin coating method, therefore simplifying the process operations and equipment applications, and further reducing the production costs. Similarly, in another specific embodiment, each photosensitive layer and both buffer layers may employ small molecules formed by vacuum evaporation method. For example, the electron donor material in the photosensitive layer 13 and the photosensitive layer 23 may employ phthalocyanine dye, pentacene, porphyrin or cyanine dye, the electron acceptor material may employ a tetracarboxyperylene derivative (e.g. perylene-3,4,9,10-tetracarboxylic dianhydride, PTCDA), C₆₀, C₇₀, perylene or a derivative thereof; and both buffer layers may employ a conductive film such as TiOₓ, BCP, Alq₃ or LiF. In this way, all the layers may be prepared by vacuum evaporation method. In this case, multiple successive steps may all employ vacuum evaporation method. Further advantageously, the transparent electrode 16 and the light reflective electrode 11 may both be formed by vacuum evaporation method. This further simplifies the process operations and equipment applications, and further reduces the production costs.

The structures of the organic solar cells 10 and 20 in the embodiments of the present invention, the method for preparing the same, and the properties of the same are illustrated with the following specific Examples.

### Example 1

Refer to Figure 1 for the structure of the present example, wherein the light reflective electrode 11 employs Al film electrode; the first buffer layer 12 employs LiF film; the photosensitive layer 13 employs P3HT:PC₇₀BM polymeric mixture heterojunction film; the second buffer layer 15 employs PEDOT:PSS polymeric film; the transparent electrode 16 employs ITO stripe-like electrode which has a transmittance of 85% in the visible light range; the transparent insulation layer 17 employs quartz glass; and the up-conversion structure 18 employs Yb³⁺/Er³⁺ co-doped sodium yttrium fluoride film. The thickness of each layer is described in the following preparation method.

The organic solar cell 10 in the above example is prepared as follows.
(1) Quartz glass is used as the substrate, and a layer of ITO conductive film is formed on one side of the quartz glass by sputtering. The thickness of the quartz glass is about 1.1 mm, and the thickness of the ITO film is about 110 nm, and its sheet resistance is 15-17 Ω/sq.
(2) The ITO conductive film is photo-etched to desired stripe-like electrode pattern, and used as the anode, to prepare the ITO electrode sheet.
(3) The whole ITO electrode sheet is wiped with anhydrous methanol and acetone, and sonicated in anhydrous methanol for 1-1.5 h, followed by heating the ITO electrode sheet at 150°C for 15 minutes in a furnace, to conduct a surface pretreatment on the ITO electrode sheet.
(4) A PEDOT:PSS film is spin coated on the ITO electrode sheet, with a spin speed of 5000 rpm. The film has a thickness of about 35 nm. The spin coated product is placed in an oven and heated at 90°C for 25 minutes.
(5) 5 ml chloroform is used as the solvent for preparing P3HT:PC₇₀BM mixed film by wet method. The mass ratio of P3HT and PC₇₀BM is 1:0.8, wherein the mass percentage concentration of P3HT in chloroform is 1 wt%, and the mass percentage concentration of PC₇₀BM in chloroform is 0.8 wt%. The resulted solution is sufficiently agitated with a magnetic stirrer, and stored for preparing a film by spin coating in a wet method.
(6) The PC₇₀BM solution and the P3HT solution prepared in step (5) is spin coated on the PEDOT:PSS film to prepared the P3HT:PC₇₀BM photosensitive layer. The spin speed is 1500 rpm, and the film has a thickness of about 150 nm.
(7) The product formed in step (6) is placed in a vacuum oven and heated at 80°C for 10 minutes, and then taken out.
(8) The product formed in step (7) is transferred into a vacuum evaporation chamber with a pressure of below 10⁻⁶Pa. A LiF film is prepared on the P3HT:PC₇₀BM mixed photosensitive layer, with a thickness of 0.5 nm, and growth rate in the evaporation is 0.005 nm/s.
(9) A stripe-like electrode mask sheet is formed on the LiF film by vacuum evaporation of aluminum stripe-like electrode with a thickness of 120 nm, which is used as the cathode of the polymeric solar cell.
(10) On the non-deposited side of the quartz glass, a layer of Yb³⁺/Er³⁺ co-doped sodium yttrium fluoride film is prepared by sol-gel method. The whole structure is applied with 2.5 V external bias at the ITO anode, and annealed simultaneously at 160°C for 5 minutes. In this way, the manufacturing of an example of the organic solar cell 10 is achieved.

### Example 2

Refer to Figure 2 for the structure of the present example, wherein the light reflective electrode 11 employs ZnO film electrode; the first buffer layer 12 employs Alq₃ film; the first photosensitive layer 23a employs C₆₀ film; the third photosensitive layer 23c employs a mixed heterojunction film formed by mixed deposition of CuPc phthalocyanine copper and C₆₀; the second photosensitive layer 23b employs CuPc phthalocyanine copper film; the second buffer layer 15 empolys PEDOT:PSS polymeric film; the transparent electrode 16 employs ITO stripe-like electrode which has a sheet resistance of 15 Ω/sq and a transmittance of 85% in the visible light range; the transparent insulation layer 17 employs quartz glass: and the up-conversion structure 18 employs Yb³⁺/Er³⁺ co-doped sodium yttrium fluoride film. The thickness of each layer is described in the following preparation method.

The organic solar cell 20 in the above example is prepared as follows.
(1) Quartz glass is used as the substrate, and a layer of ITO conductive film is formed on one side of the quartz glass by sputtering. The thickness of the quartz glass is about 1.1 mm, and the size thereof is 37 cm x 48 cm.
(2) The ITO conductive film is photo-etched to desired stripe-like electrode pattern, and used as the anode of the solar cell.
(3) A PEDOT:PSS film is spin coated on the ITO transparent electrode. The spin coated product is placed in an oven and heated at 85°C for 25 minutes.
(4) The spin coated product is taken out from the oven and transferred into the growing chamber of a vacuum evaporation system with a pressure of about 10⁻⁸ Torr. A CuPc phthalocyanine copper electron donor layer is grown by vacuum evaporation to a thickness of 20 nm at a growth rate of 0.3 nm/s.
(5) A mixed deposition layer of CuPc and C₆₀ is grown on the CuPc film at a volume ratio of 1:0.5, wherein the growth rate of CuPc is 0.3 nm/s, the growth rate of C₆₀ is 0.15 nm/s, and the thickness of the mixed deposition layer is 10 nm. A mixed heterojunction structure of the donor and acceptor materials is formed.
(6) A C₆₀ electron acceptor layer is formed on the CuPc film by vacuum evaporation to a thickness of 35 nm at a growth rate of 0.4 nm/s.
(7) 8-Tris-Hydroxyquinoline Aluminum Alq₃ is formed on the C₆₀ film by vacuum evaporation to a thickness of 5 nm at a growth rate of 0.2 nm/s.
(8) A stripe-like electrode mask sheet is formed on the Alq₃ film by vacuum evaporation of zinc oxide stripe-like electrode with a thickness of 110 nm.
(9) On the non-deposited side of the quartz glass, a layer of Yb³⁺/Er³⁺ co-doped sodium yttrium fluoride film is prepared by sol-gel method. The whole structure is annealed at 115C for 15 minutes. In this way, the manufacturing of an example of the organic solar cell 20 is achieved.

In the above organic solar cells, on one hand, by arranging an up-conversion structure and utilizing the spectral conversion function of the up-conversion material, the lights which cannot be sufficiently absorbed and utilized by the cell, such as low-energy near IR photons, are converted to photons of visible wavelengths which have relatively higher energy, thereby increasing the utilization rate of sunlight energy by the organic solar cell, and improving its photoelectric conversion performance. On the other hand, the transparent insulation layer between the up-conversion structure and the transparent electrode ensures electrical separation of the up-conversion layer and the solar cell, avoiding the adverse effects of the up-conversion material on the photoelectric conversion of the solar cell, and enhancing the electric properties of the organic solar cell. Furthermore, by utilizing the mixed heterojunction structure, the exciton dissociation region is expanded, and the exciton utilization rate is increased, thereby increasing the internal quantum efficiency of the cell. In the method for manufacturing the organic solar cell, various layers are formed in predetermined steps, the procedure is simple with low costs, thereby having broad application prospect.

The examples described above are only preferred embodiments of the present invention, and are intended to limit the present invention. Any amendment, equivalent substitution and improvement within the spirit and principle of the present invention fall within the scope of the present invention.

## Claims

1. An organic solar cell (10, 20), comprising a light reflective electrode (11), a photosensitive layer (13, 23) arranged on the light reflective electrode, a transparent electrode (16) arranged on the photosensitive layer, wherein the organic solar cell further comprises an up-conversion structure (18) arranged on the transparent electrode, and a transparent insulation layer (17) arranged between the transparent electrode and the up-conversion structure, the up-conversion structure comprises an up-conversion material having up-conversion capability for spectrum, and the photosensitive layer comprises at least a mixed heterojunction structure formed by mixing an electron donor material and an electron acceptor material.

2. The organic solar cell according to Claim 1, wherein the up-conversion material comprises halide, oxide, sulfide or a combination thereof which is mono- or double-doped with rare earth ions.

3. The organic solar cell according to Claim 1, wherein the up-conversion material comprises BaY₂F₈, KZnF₃, NaYF₄, NaYb(WO₄)₂, Ga₂S₃-La₂O₃, Y₂O₃, Gd₂O₃, ZrO₂, ZnO, BaTiO₃, ZrF₂-SiO₂ or ZnO-SiO₂ which is mono- or double-doped with rare earth ions.

4. The organic solar cell according to Claim 2 or 3, wherein the mono- or double-doped rare earth ions include Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ or Tb³⁺/Er³⁺.

5. The organic solar cell according to Claim 1, wherein the up-conversion structure is in a form of a film comprising an up-conversion material, or of a composite structure comprising an up-conversion material coated with an oxide film.

6. The organic solar cell according to Claim 1, wherein the photosensitive layer further comprises a first photosensitive layer (23a) and a second photosensitive layer (23b), the mixed heterojunction structure is a third photosensitive layer (23c) and is arranged between the first photosensitive layer and the second photosensitive layer, the first photosensitive layer comprises an electron donor material in the mixed heterojunction structure, and the second photosensitive layer comprises an electron acceptor material in the mixed heterojunction structure.

7. The organic solar cell according to Claim 1, wherein the organic solar cell further comprises a first buffer layer (12) arranged between the light reflective electrode (11) and the photosensitive layer (13, 23), and a second buffer layer (15) arranged between the photosensitive layer and the transparent electrode (16), and the materials for the first and the second buffer layers is selected from polyethylenedioxythiophene : polystyrenesulfonate composite, titanium oxides, BCP, Alq₃ or LiF.

8. The organic solar cell according to Claim 1, wherein the electron donor material for the photosensitive layer is selected from polyphenylenevinylene and derivatives thereof, polythiophene materials, polyfluorene materials, polycarbazole materials, polydithienocyclopentane materials and polymers containing quinoxaline, thienopyrrole, or thienopyrazine; the electron acceptor material for the photosensitive layer is polyperylene imide material; and the material for each of the buffer layers is polyethylenedioxythiophene : polystyrenesulfonate composite.

9. The organic solar cell according to Claim 1, wherein the electron donor material for the photosensitive layer is selected from phthalocyanine dyes, pentacene, porphyrins and cyanine dyes; the electron acceptor material for the photosensitive layer is selected from tetracarboxyperylene derivatives, C₆₀, C₇₀, perylene and derivatives thereof; and the material for each of the buffer layers is selected from titanium oxides, BCP, Alq₃ and LiF.

10. A method for manufacturing an organic solar cell, comprising the following steps:
providing a transparent insulation layer having a first surface and a second surface opposite to each other;
forming a transparent electrode on the first surface of the transparent insulation layer;
forming a photosensitive layer on the transparent electrode, wherein the photosensitive layer comprises at least a mixed heterojunction structure formed by mixing an electron donor material and an electron acceptor material;
forming a light reflective electrode on the photosensitive layer;
forming an up-conversion structure on the second surface of the transparent insulation layer, thereby the transparent insulation layer is between the transparent electrode and the up-conversion structure, wherein the up-conversion structure comprises an up-conversion material having up-conversion capability for spectrum.

11. The method for manufacturing an organic solar cell according to Claim 10, wherein the photosensitive layer further comprises a first photosensitive layer and a second photosensitive layer, the mixed heterojunction structure is a third photosensitive layer and is arranged between the first photosensitive layer and the second photosensitive layer, the first photosensitive layer comprises an electron donor material in the mixed heterojunction structure, and the second photosensitive layer comprises an electron acceptor material in the mixed heterojunction structure.

12. The method for manufacturing an organic solar cell according to Claim 11, wherein the three photosensitive layers are all formed by one of spin coating or vacuum evaporation.

13. The method for manufacturing an organic solar cell according to Claim 10, wherein the up-conversion structure is formed by depositing the up-conversion material on the second surface of the transparent insulation layer by sol-gel method, or by forming the up-conversion material coated by an oxide film on the second surface of the transparent insulation layer by chemical co-precipitation method.

14. The method for manufacturing an organic solar cell according to Claim 10, wherein the photosensitive layer is formed by spin coating; and the electron donor material and the electron acceptor material are dissolved in an organic solvent in advance before conducting the spin coating, and sufficiently stirred with a magnetic stirrer to prepare a solution containing the electron donor material and the electron acceptor material; the electron donor material solution and the electron acceptor material solution are spin coated to prepare the photosensitive layer.
